# EUROPÄISCHE PATENTSCHRIFT

(11) **EP 2 442 125 B1**
(45) Veröffentlichungstag und Bekanntmachung des Hinweises auf die Patenterteilung: **04.04.2018**
(21) Anmeldenummer: 11008254.2
(22) Anmeldetag: 13.10.2011
(51) Int. Cl.: G01R 31/36, G01R 19/165

(54) **Verfahren und Vorrichtung zum Überwachen der maximal verfügbaren Kapazität einer Batterie**
Method and device for monitoring the maximum available capacity of a battery
Procédé et dispositif de surveillance de la capacité maximale disponible d'une batterie

(30) Priorität: 13.10.2010 DE 102010048187
(43) Veröffentlichungstag der Anmeldung: 18.04.2012
(73) Patentinhaber: Phoenix Contact GmbH & Co. KG, 32825 Blomberg (DE)
(72) Erfinder: Henkel, Hartmut, 32825 Blomberg (DE); Neuendorf, Andreas, 32839 Steinheim (DE); Heinemann, Michael, 32791 Lage (DE); Wattenberg, Mike, 33818 Leopoldshöhe (DE)
(74) Vertreter: Kampfenkel, Klaus

(56) Entgegenhaltungen:
- EP-A2- 1 450 173
- EP-A2- 1 482 318
- WO-A1-2007/048367
- DE-A1- 19 540 827
- US-A- 5 808 445

## Beschreibung

Die Erfindung betrifft ein Verfahren sowie eine Vorrichtung zum Überwachen der maximal verfügbaren Kapazität einer Batterie sowie eine unterbrechungsfreie Stromversorgung, welche eine solche Vorrichtung zum Überwachen der maximal verfügbaren Kapazität einer Batterie aufweist.

Um eine unterbrechungsfreie Stromversorgung bereitzustellen, wird neben dem Netzbetrieb bei dessen Ausfall auch ein Betrieb über Batterien, insbesondere wieder aufladbare Batterien, vorgesehen. Um eine zuverlässige Energieversorgung in industriellen Anlagen, Kraftfahrzeugen und vielen anderen Bereichen bereitstellen zu können, ist es erforderlich, den Batteriezustand (state of health; SOH), die aktuellen Batteriekapazität, den Batterie-Ladezustand und zahlreiche weitere Parameter einer Batterie zu überwachen. Hierzu sind bereits zahlreiche Lösungsansätze bekannt.

So ist beispielsweise in der DE 199 52 693 A1 eine Vorrichtung zum Ermitteln und Anzeigen des Zustands einer Batterie erläutert. Mit der bekannten Vorrichtung kann insbesondere der Ladezustand einer Batterie ermittelt werden. Hierzu weist die Vorrichtung Sensoren zum Erfassen der Batteriespannung, der Batterietemperatur, des Batteriestroms (Ladestrom oder Entladestrom) auf. Weiterhin verfügt die bekannte Vorrichtung über eine Auswerteschaltung, die den Batteriezustand aus den gemessenen Werten ermitteln kann. Zudem ist die bekannte Vorrichtung in der Lage, eine Lade- und/oder Entladebilanz der Batterie für die Ermittlung des Energiedurchsatzes in Abhängigkeit der Entladetiefe zu ermitteln. Hierbei wird unter anderem auch die Batterietemperatur berücksichtigt.

Aus der DE 38 32 839 C2 ist zudem ein Verfahren zur Überwachung von wiederaufladbaren Batterien bekannt. Das Verfahren dient unter anderem dazu, die einer Batterie entnehmbare Kapazität für verschiedene Entladeströme im Verhältnis der zugehörigen Werte der Entladekennlinie zu berechnen. Auf diese Weise kann festgestellt werden, wenn die entnehmbare Kapazität für einen vorgesehenen Entladestrom unter einen zulässigen Mindestwert sinkt. Dieses Verfahren berücksichtigt den sogenannten Peukert-Effekt, der besagt, dass mit steigendem Entladestrom einer Batterie immer weniger Energie entnommen werden kann.

Aus DE 40 07 883 A1 ist ein Verfahren zum Bestimmen des Zustandes einer Batterie bekannt, bei dem ein nach Stromentnahme gemessener Wert der Batteriespannung, die sogenannte Entladeschlussspannung, mit einem Spannungswert, welcher aus einer im Speicher abgelegten Ladungszustandskurvenschar ermittelt wird, verglichen und die Spannungsdifferenz aus beiden Werten bestimmt wird. Diese Spannungsdifferenz wird mit gespeicherten Kenndaten für den jeweiligen Batterietyp verglichen und daraus die Abnahme der maximal verfügbaren Batteriekapazität bestimmt.

Aus DE 10 2007 029 156 A1 ist ein Überwachungs- und Steuersystem für mehrere in Reihe geschaltete Batterien bekannt, deren Potentiale abgegriffen und ausgewertet werden, um die Lebensdauer der Batterien in Hybridfahrzeugen zu optimieren.

Aus WO 2007/048367 A1 ist ein Verfahren zur Bestimmung eines Alterungszustandes einer Batterie bekannt, bei welchem als Parameter der Batterie insbesondere Ladezustand, Temperatur, Ladestrom und/oder Entladestrom erfasst oder bestimmt werden, wobei jeweils zwei von den Parametern als Parameterpaar vorgegeben und derart zueinander in Beziehung gesetzt werden, dass dem jeweiligen Parameter zugrunde liegende Parameterbereiche und daraus resultierende Wertepaare des vorgegebene Parameterpaares klassifiziert gewichtet werden, um eine einfache und schnelle sowie speicherplatzsparende Analyse des Alterungszustands der Batterie zu ermöglichen.

Der Erfindung liegt nunmehr die Aufgabe zugrunde, ausgehend von den bekannten Lösungsansätzen, ein Verfahren sowie eine Vorrichtung zur Verfügung zu stellen, mit denen der aktuelle Ladezustand einer Batterie genauer ermittelt werden kann, um auf diese Weise präzise Prognosen über die noch zu erwartende Batterielaufzeit abgeben zu können.

Ein Kerngedanke der Erfindung ist darin zu sehen, ein Verfahren bereitzustellen, mit welchem die aktuelle Batteriequalität zu vorbestimmbaren Zeitpunkten geprüft werden kann. Der Wert der Batteriequalität gibt darüber Auskunft, wie groß die maximal verfügbare Batteriekapazität im Verhältnis zur Nennkapazität ist. Unter Nennkapazität wird die theoretisch in der Batterie maximal speicherbare elektrische Ladung bezeichnet. Mit maximal verfügbarer Kapazität wird hingegen die Ladungsmenge bezeichnet, die der Batterie tatsächlich maximal entnehmbar ist. Die maximal verfügbare Batteriekapazität ist von zahlreichen Faktoren, wie zum Beispiel der Batterietemperatur, der Einsatzdauer und dem Innenwiderstand der Batterie abhängig.

Die vorliegende Erfindung kann vorzugsweise in industriellen Anlagen zum Einsatz kommen, in denen USV-Geräte (unterbrechungsfreie Stromversorgungen, USV) eingesetzt werden. USV-Geräte sorgen im Falle eines Stromausfalls dafür, dass Teile der Anlage und deren Steuerung für eine bestimmte Zeit weiter betrieben und dann definiert heruntergefahren werden können. Eine genaue Kenntnis über die aktuelle Batterielaufzeit ist deshalb erforderlich, da bei einer fehlerhaften Kalkulation der Batterielaufzeit die Batteriespannung der USV ausfallen kann, bevor der Verbraucher heruntergefahren ist.

Demzufolge ist die Kenntnis des aktuellen Ladezustands und des aktuellen Stromverbrauchs im Batteriebetrieb erforderlich, um genaue Prognosen über die noch zu erwartende Batterielaufzeit durchführen zu können. Eine solche Prognose ermöglicht es, nach einem Stromausfall die Anlage mittels der eingesetzten USV-Geräte noch für eine bestimmte Dauer, die sogar der maximalen Laufzeit entsprechen kann, weiterzubetreiben, um zuletzt noch ausreichend Batterieenergie zur Verfügung zu haben, um die Verbraucher sicher herunterfahren zu können. Der aktuelle Ladezustand kann mittels einer Lade- und Entladebilanzierung ermittelt werden.

Da zu einer präzisen Ladungsbilanzierung die aktuelle, d. h. maximal verfügbare Kapazität der Batterie präzise bekannt sein sollte, wird erfindungsgemäß ein Verfahren zum Überwachen der maximal verfügbaren Kapazität einer Batterie zur Verfügung gestellt.

Gemäß dem Verfahren wird eine Mehrzahl von verschiedenen Entladeschlussspannungswerten, denen jeweils ein Zähler zugeordnet wird, bereitgestellt. Nunmehr wird der Batterie Strom entnommen und der Entladeschlussspannungswert, auf den die Batterie entladen worden ist, ermittelt. Anschließend wird der Zählerstand des Zählers, welcher dem ermittelten Entladeschlussspannungswert zugeordnet ist, inkrementiert. Für jeden weiteren Vorgang der Stromentnahme werden die zuvor genannten Verfahrensschritte wiederholt.

Zu einem vorbestimmbaren Zeitpunkt wird der Zählerstand jedes Zählers ausgelesen. In Abhängigkeit von den ausgelesenen Zählerständen wird ein erster Faktor ermittelt, welcher ein Maß für die Abnahme der maximal verfügbaren Batteriekapazität darstellt. Angemerkt sei, dass die Stromentnahme bzw. die Entladevorgänge nicht speziell für Messzwecke erzwungen werden, sondern sich aus dem normalen Batteriebetrieb ergeben.

Dank der Berücksichtigung mehrerer Entladeschlussspannungswerte kann die Beeinträchtigung der maximal verfügbaren Kapazität einer Batterie in Abhängigkeit von der Entladetiefe eines Entladevorgangs präziser ermittelt werden.

Wie bereits eingangs erwähnt, ist die Kenntnis der genauen maximal verfügbaren Batteriekapazität zum Ermitteln des aktuellen Ladezustands der Batterie erforderlich.

Eine Möglichkeit, den ersten Faktor zu bestimmen, besteht darin, für jeden zu überwachenden Batterietyp Messreihen aufzustellen, die als Parameter die verschiedenen Entladeschlussspannungswerte aufweisen und über die Anzahl der Entladevorgänge aufgetragen werden. In diesem Fall gehört zu jedem Zählerstand für einen Entladeschlussspannungswert ein bestimmter Wert, der angibt, inwieweit die maximal verfügbare Kapazität gegenüber der Nennkapazität abgenommen hat.

Um die Batteriequalität, d.h. den Wert der Abnahme der maximal verfügbaren Batteriekapazität gegenüber der Nennkapazität noch präziser angeben zu können, wird die Batterietemperatur gemessen und der Zählerstand des jeweiligen Zählerstandes temperaturgewichtet inkrementiert.

Der Grad der Temperaturgewichtung kann aus verschiedenen Messreihen zu dem jeweiligen Batterietyp abgelesen werden, welche für verschiedene Batterietemperaturen erstellt worden sind.

Die maximal verfügbare Batteriekapazität kann noch genauer bestimmt werden, indem die Batterietemperatur und die Einsatzdauer der Batterie gemessen wird. Aus der gemessenen Batterietemperatur und der gemessenen Einsatzdauer wird dann ein zweiter Faktor ermittelt, welcher ein weiteres Maß für die Abnahme der maximal verfügbaren Batteriekapazität ist. Angemerkt sei an dieser Stelle, dass aus der gemessenen Einsatzdauer der Batterie auf deren Lebensdauer geschlossen werden kann.

Um noch präzisere Aussagen über die maximal verfügbare Batteriekapazität gewinnen zu können, wird der Innenwiderstand der Batterie ermittelt. In Abhängigkeit von dem ermittelten Innenwiderstand wird ein dritter Faktor bestimmt, welcher ein weiteres Maß für die Abnahme der maximal verfügbaren Batteriekapazität darstellt.

Um den aktuellen Ladezustand der Batterie ermitteln zu können, wird eine Ladestrom- und Entladestrombilanzierung, kurz Ladungsbilanzierung genannt, durchgeführt. Hierzu können an sich bekannte Ladungsbilanzierungsmethoden angewendet werden. Wird zudem im Batteriebetrieb der aktuelle Entladestrom gemessen, so kann in Abhängigkeit vom aktuellen Ladezustand, vom aktuellen Entladestrom und von der maximal verfügbaren Batteriekapazität die zu erwartende Batterielaufzeit ermittelt werden. Dank solcher Maßnahmen ist es möglich, nach einem Stromausfall des Netzes die Anlage mittels der eingesetzten USV-Geräte noch für eine bestimmte Dauer, die sogar der maximalen Laufzeit entsprechen kann, weiterzubetreiben. Zudem wird dadurch sichergestellt, dass nach Ablauf der maximalen Laufzeit noch eine ausreichend hohe Batterieenergie zur Verfügung steht, um die Verbraucher sicher herunterfahren zu können.

Die für den zu überwachenden Batterietyp gewählten Kennwerte werden bei der Lade- und Entladestrombilanzierung zusammen mit dem gemessenen, aktuellen Batteriestrom, der aktuellen Batterietemperatur und/oder der aktuellen Batteriebespannung verwendet, um daraus den aktuellen Ladezustand zu ermitteln.

Bei den Kennwerten der Batterie kann es sich um die Nennspannung, die Lebensdauer, die Nennkapazität, die Innenwiderstandscharakteristik, das Temperaturverhalten und weitere Parameter handeln. Diese Werte werden vorab mithilfe zahlreicher Messreihen ermittelt und zur Durchführung des Verfahrens mitberücksichtigt.

Zur Lösung des oben genannten technischen Problems wird eine Vorrichtung zum Überwachen der maximal verfügbaren Kapazität einer Batterie geschaffen. Die Vorrichtung weist eine Speichereinrichtung auf, in welcher mehrere verschiedene Wertbereiche der nach Schluss der Stromentnahme noch vorhandenen Ladung angelegt sind. Dieser Ladung entspricht ein jeweiliger Entladeschlussspannungswert. Weiterhin weist die Vorrichtung mehrere Zähler auf, die jeweils einem der Wertebereiche der Entladeschlussspannung zugeordnet sind. Eine Steuer- und Auswerteeinrichtung ist dazu ausgebildet, den Wertbereich der Entladeschlussspannung, auf den die Batterie durch einen jeweiligen Stromentnahmevorgang entladen worden ist, zu ermitteln, das Inkrementieren des Zählerstandes des Zählers, welcher dem ermittelten Wertbereich der Entladeschlussspannung zugeordnet ist, zu steuern, den Zählerstand jedes Zählers auszulesen und in Abhängigkeit von den ausgelesenen Zählerständen einen ersten Faktor zu bestimmen, welcher ein Maß für die Abnahme der maximal verfügbaren Batteriekapazität darstellt.

Um präzisere Angaben über die Abnahme der maximal verfügbaren Batteriekapazität angeben zu können, ist ein Temperaturdetektor zum Messen der aktuellen Batterietemperatur und eine Einrichtung zum Messen der Einsatzdauer der Batterie vorgesehen. Die Steuer- und Auswerteeinrichtung ist derart ausgebildet, dass sie aus der gemessenen Batterietemperatur und der gemessenen Einsatzdauer einen zweiten Faktor ermitteln kann, welcher ein weiteres Maß für die Abnahme der maximal verfügbaren Batteriekapazität darstellt.

Weiterhin ist die Steuer- und Auswerteeinrichtung in der Lage, den Innenwiderstand der Batterie zu ermitteln, um in Abhängigkeit von dem ermittelten Innenwiderstand einen dritten Faktor bestimmen zu können, welcher ein weiteres Maß für die Abnahme der maximal verfügbaren Batteriekapazität darstellt.

Um eine präzise Aussage über die aktuell verfügbare maximale Batteriekapazität geben zu können, kann die Steuer- und Auswerteeinrichtung in Abhängigkeit von dem ersten und zweiten und/oder dritten Faktor die maximal verfügbare Batteriekapazität ermitteln.

Um den aktuellen Ladezustand der Batterie ermitteln zu können, weist die Vorrichtung eine weitere Speichereinrichtung zum Speichern der Kennwerte der Batterie, einen Spannungsdetektor zum Detektieren der aktuellen Batteriespannung und einen Stromdetektor zum Detektieren des aktuellen Batteriestroms auf. Die Steuer- und Auswerteeinrichtung ist weiterhin dazu ausgebildet, eine Ladungsbilanzierung durchzuführen.

Die erfindungsgemäße Vorrichtung zum Überwachen der maximal verfügbaren Kapazität einer Batterie wird in eine Netzanschlusseinrichtung zu einer unterbrechungsfreien Stromversorgung des Verbrauchers integriert.

Angemerkt sei, dass die Informationen, die zur Bestimmung der aktuellen Kapazität der Batterie verwendet werden, während des Betriebs des USV-Geräts ermittelt werden können. Das heißt, die Batterie ist in diesem Fall permanent am USV-Gerät angeschlossen.

Die Erfindung wird nachfolgend anhand eines Ausführungsbeispiels in Verbindung mit den beiliegenden Zeichnungen näher erläutert. Es zeigen:
- Fig. 1A und 1B: ein Flussdiagramm, welches die Ladungsbilanzierung und die Ermittlung der Batteriequalität erläutert,
- Fig. 2: eine unterbrechungsfreie Stromversorgung, in welcher die Erfindung verwirklicht ist.

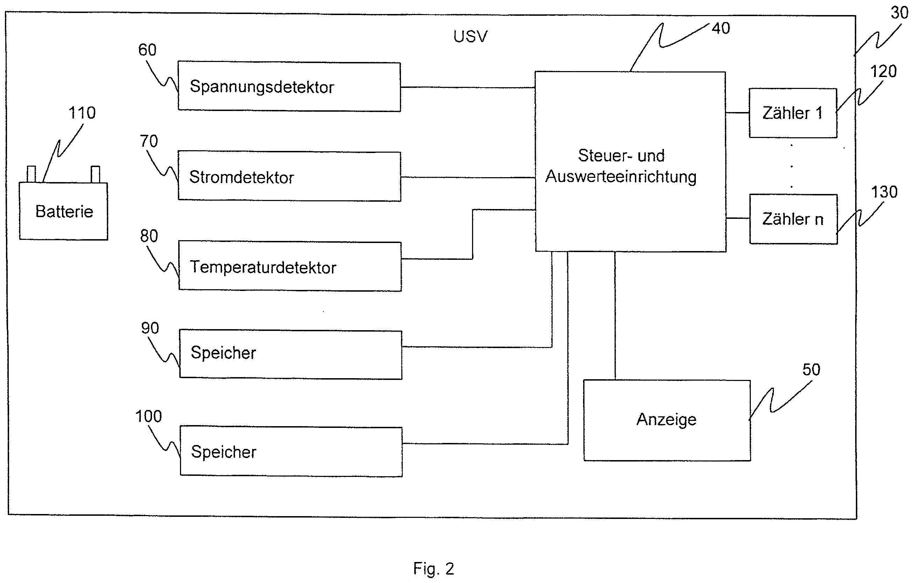

Fig. 2 zeigt ein beispielhaftes USV-Gerät 30, d. i. eine unterbrechungsfreie Stromversorgung, die in an sich bekannter Weise eine wiederaufladbare Batterie 110 enthält. Mit dem USV-Gerät 30 können bei Stromausfall elektrische Geräte oder Anlagen vorübergehend weiter mit Energie versorgt und anschließend sicher heruntergefahren werden. Zur Überwachung der Batterie 110 weist das USV-Gerät 30 mehrere Sensoren oder Detektoren, wie zum Beispiel einen Spannungsdetektor 60, einen Stromdetektor 70 und einen Temperaturdetektor 80 auf. Der Spannungsdetektor 60 misst zu einstellbaren Zeitpunkten oder kontinuierlich die aktuelle Batteriespannung. Der Stromdetektor 70 misst zu einstellbaren Zeitpunkten oder kontinuierlich den aktuellen Batteriestrom. Je nach Batteriebetrieb entspricht der Batteriestrom dem Entladestrom oder dem Ladestrom. Mit dem Temperaturdetektor 80 wird zu einstellbaren Zeitpunkten oder kontinuierlich die Batterietemperatur gemessen. Die gemessenen Werte der Detektoren 60, 70 und 80 werden einer Steuer- und Auswerteeinrichtung 40 zugeführt. Ein Speicher 90 ist vorgesehen, in welchem mehrere verschiedene Wertbereichte der Entladeschlussspannung abgelegt sind. Wie unten noch näher ausgeführt wird, dienen die Wertbereiche der Entladeschlussspannung dazu, die Entladetiefe der Batterie 110 bei jeder Stromentnahme zu ermitteln.

Weiterhin ist ein Speicher 100 vorgesehen, in welchen die Kennwerte der Batterie 110, zum Beispiel während der Initialisierungsphase, geladen werden. Angemerkt sei, dass die im Speicher 100 abgelegten Kennwerte der Batterie zuvor mithilfe einer Reihe von Messdurchläufen an einem Batterietyp, welcher der Batterie 110 entspricht, bestimmt worden sind. Die Inhalte der Speicher 90 und 100 können von der Steuer- und Auswerteeinrichtung 40 ausgelesen werden. Über eine Anzeigeeinrichtung 50 können die von der Steuer- und Auswerteeinrichtung 40 ermittelten Ergebnisse optisch ausgegeben werden. Weiterhin sind an die Steuer- und Auswerteeinrichtung mehrere Zähler 120, 130 angeschlossen, die jeweils einem Wertbereich der in Speicher 90 hinterlegten Wertebereiche der Entladeschlussspannung zugeordnet sind. Diese Zuordnung kennt die Steuer- und Auswerteeinrichtung.

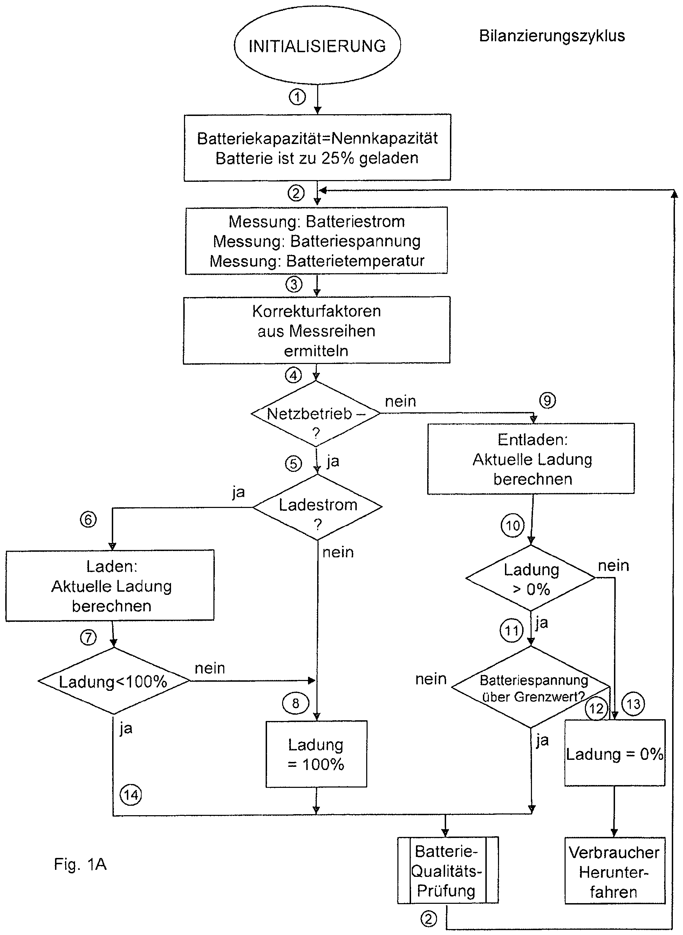

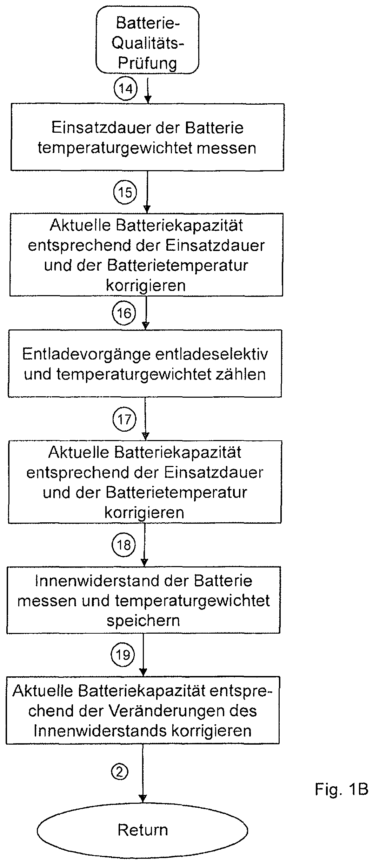

Die von der Steuer- und Auswerteeinrichtung 40 durchgeführte Ladungsbilanzierung und Überwachung der Batteriequalität wird nachfolgend anhand des in den Fig. 1A und 1B gezeigten Flussdiagramms näher erläutert. Der durch das Flussdiagramm dargestellte beispielhafte Ladungsbilanzierungsalgorithmus kann von der Steuer- und Auswerteeinrichtung 40 ausgeführt werden.

Angenommen sei zunächst, dass die Ladungsbilanzierung hinsichtlich der Batterie 110 erstmals durchgeführt werden soll. Beim Start der Bilanzierung, der in Fig. 1A durch den Schritt "Initialisierung" dargestellt ist, wird die Steuer- und Auswerteeinrichtung 40 zunächst initialisiert. Hierzu werden alle Kennwerte der Batterie eingelesen und im Speicher 100 abgelegt. Wenn bei der ersten Inbetriebnahme der Ladungszustand der Batterie 110 nicht bekannt ist, wird in Schritt 1 die aktuelle Ladung der Batterie 110 auf 25% gesetzt. Auf diese Weise ist sichergestellt, dass ein sofortiger Batteriebetrieb des USV-Geräts 30 möglich ist. Weiterhin wird die Batteriekapazität, das ist im Nachfolgenden die maximal verfügbare Batteriekapazität, gleich der Nennkapazität gesetzt. In Schritt 2 beginnt nunmehr die Messung des Batteriestroms, der Batteriespannung und der Batterietemperatur mittels des Stromdetektors 70, des Spannungsdetektors 60 bzw. des Temperaturdetektors 80. Die aktuellen Messwerte werden von den Detektoren 60 bis 80 der Steuer- und Auswerteeinrichtung 40 zugeführt. Wie in Schritt 3 des Flussdiagramms gezeigt, ermittelt die Steuer- und Auswerteeinrichtung 40 aus den im Speicher 100 gespeicherten Kennwerten der Batterie und den von den Detektoren 60 bis 80 gelieferten aktuellen Messwerten Korrekturwerte für die aktuelle Ladung, die zu Beginn auf 25% gesetzt wurde. Die Steuer- und Auswerteeinrichtung 40 kann entsprechende Kennlinien, die im USV-Gerät 30 gespeichert sind, verwenden, um die Korrekturwerte zu ermitteln. Die Korrekturwerte und Messwerte werden in jedem Ladungsbilanzierungszyklus aktualisiert.

Angenommen sei nunmehr, dass die Steuer- und Auswerteeinrichtung 40 in Schritt 4 festgestellt hat, dass der Bilanzierungszyklus sich momentan auf einen Ladebetrieb bezieht, das USV-Gerät sich also im Netzbetrieb befindet. In diesem Betriebsmodus wird die Batterie 110 über die Netzspannung aufgeladen. Der in Schritt 2 gemessene Batteriestrom entspricht somit dem aktuellen Ladestrom der Batterie. Folglich erkennt die Steuer- und Auswerteeinrichtung 40 in Schritt 5, dass ein Ladestrom fließt und der Bilanzierungsalgorithmus verzweigt zu Schritt 6. Unter Berücksichtigung der in Schritt 2 gemessenen Werte und der in Schritt 3 ermittelten Korrekturwerte wird im aktuellen Bilanzierungszyklus berechnet, welche zusätzliche Ladung die Batterie im Augenblick aufgenommen hat. Die aktuelle Ladung, die bisher auf 25% gesetzt worden ist, wird um diesen Wert inkrementiert. Anschließend fährt der Bilanzierungsalgorithmus mit Schritt 7 fort und die Steuer- und Auswerteeinrichtung 40 geprüft, ob die aktuelle Batterieladung 100% erreicht hat. Hierzu prüft die Steuer- und Auswerteeinrichtung 40, ob der in Schritt 2 gemessene Batterieladestrom unter einen bestimmten Schwellwert gesunken ist. Im vorliegenden Beispiel erkennt die Steuer- und Auswerteeinrichtung 40 in Schritt 7, dass die Batterie noch nicht voll aufgeladen ist und der Ladebetrieb wird fortgesetzt. Der Bilanzierungsalgorithmus springt folglich wieder zu Schritt 2 zurück.

Wiederum werden von der Steuer- und Auswerteeinrichtung die aktuellen Messwerte der Detektoren 60, 70 und 80 eingelesen. In Abhängigkeit von den aktuellen Messwerten und den Kennwerten der Batterie wird in Schritt 3 wiederum der Korrekturfaktor für die aktuelle Ladung ermittelt.

Angenommen sei, dass der vom Stromdetektor 70 gemessene Ladestrom den vorbestimmten Schwellwert immer noch nicht unterschritten hat, so dass in den Schritten 4 und 5 die Steuer- und Auswerteeinrichtung 40 die Abfragen jeweils mit "ja" beantwortet. Folglich wird in Schritt 6 anhand der von den Detektoren 60 bis 80 gemessenen Messwerte und der in Schritt 3 ermittelten Korrekturwerte erneut die Ladungsmenge berechnet wird, um die die Zählung der Ladung der Batterie erhöht werden soll.

In Schritt 7 erkennt die Steuer- und Auswerteeinrichtung 40 nunmehr, dass die Batterie voll geladen ist. Der Bilanzierungsalgorithmus verzweigt deshalb zu Schritt 8. In Schritt 8 beendet die Steuer- und Auswerteeinrichtung 40 den Ladebetrieb. Da der vom Stromdetektor 70 gemessene Ladestrom unter den bestimmten Schwellwert gesunken ist, beantwortet die Steuer- und Auswerteeinrichtung 40 die Abfrage in Schritt 5 mit "nein". Folglich beendet die Steuer- und Auswerteeinrichtung 40 den Ladebetrieb. Der Netzbetrieb in Schritt 4 läuft hingegen weiter. Der aktuelle Ladezustand wird fortlaufend mittels des Bilanzierungsalgorithmus überwacht.

Nunmehr sei angenommen, dass wegen Netzausfalls der Netzbetrieb in Schritt 4 beendet wird. Das USV-Gerät 30 soll deshalb im Stromentnahme- oder Entlademodus betrieben werden. Wiederum ermittelt der Spannungsdetektor 60 die aktuelle Batteriespannung, der Stromdetektor 70 den aktuellen Batteriestrom und der Temperaturdetektor 80 die aktuelle Batterietemperatur. Der vom Stromdetektor 70 gemessene Batteriestrom entspricht nunmehr der aktuellen Stromentnahme, d. h. dem gemessenen Entladestrom. In Schritt 3 werden, wie zuvor beschrieben, anhand der aktuellen Messwerte und der Kennwerte in der Steuer- und Auswerteeinrichtung 40 Korrekturfaktoren ermittelt. Der Bilanzierungsalgorithmus verzweigt nunmehr in Schritt 4 zu Schritt 9. Die Korrekturwerte werden zusammen mit den aktuellen Messwerten in Schritt 9 zur Berechnung der Ladungsmenge verwendet, die die Batterie im aktuellen Bilanzierungszyklus abgegeben hat. Die aktuelle Ladung der Batterie 110 wird um diesen Wert dekrementiert.

Angemerkt sei an dieser Stelle, dass der im Batteriebetrieb vom Stromdetektor 70 gemessene Entladestrom gemäß dem Peukert-Effekt die maximal entnehmbare Ladung der Batterie 110 bestimmt. Die Steuer- und Auswerteeinrichtung 40 ist dazu ausgebildet, im Batteriebetrieb bzw. Entlademodus in Abhängigkeit von dem aktuell ermittelten Ladezustand der Batterie und dem aktuell gemessenen Entladestrom eine Prognose über die Batterielaufzeit zu geben. Der entsprechende Wert kann an der Anzeige 50 dargestellt werden.

In Schritt 10 prüft die Steuer- und Auswerteeinrichtung 40, ob die aktuell berechnete Ladung größer als die vorgesehene Restladung zum Herunterfahren des Verbrauchers ist, was durch das Symbol "> 0%" in Fig. 1A wiedergegeben wird. Wenn ja, verzweigt der Bilanzierungsalgorithmus zu Schritt 11.

In Schritt 11 prüft die Steuer- und Auswerteeinrichtung 40, ob die aktuelle Batteriespannung auf die niedrigste Entladeschlussspannung gesunken ist. Ist dies der Fall, wird die Batterie als mit der vorgesehenen Restladung geladen angenommen und der Verbraucher wird heruntergefahren. Dies geschieht auch, wenn im Schritt 10 die vorgesehene Restladung erreicht wird.
Wurde allerdings die niedrigste Entladeschlussspannung nicht unterschritten, kann die Batterie 110 weiterhin entladen werden und der Bilanzierungsalgorithmus springt zu Schritt 2. Das USV-Gerät 30 kann folglich nach wie vor im Entladebetrieb arbeiten. Stellt die Steuer- und Auswerteeinrichtung 40 in Schritt 11 jedoch fest, dass die vom Spannungsdetektor 60 gemessene, aktuelle Batteriespannung kleiner als die niedrigste Entladeschlussspannung ist, wird der Entladevorgang insofern beendet, als nur noch der Verbraucher heruntergefahren wird. Die Steuer- und Auswerteeinrichtung 40 kann auf der Anzeigeeinrichtung 50 eine entsprechende Information ausgeben, dass die USV-30 nicht mehr einsatzbereit ist.

Die Steuer- und Auswerteeinrichtung 40 ist somit derart ausgebildet, dass sie in Abhängigkeit von der vorgesehenen Restladung als der ermittelten aktuellen Batterieladung den Shutdown eines an das USV-Gerät 30 angeschlossenen Verbrauchers so rechtzeitig auslöst, dass dieser noch sicher heruntergefahren werden kann. Erst nach dem Shutdown wird die aktuelle Batteriespannung unter die Entladeschlussspannung sinken.

Wenn die Netzspannung wiederkommt, beginnt der Netzbetrieb und die Steuer- und Auswerteeinrichtung 40 sorgt dafür, dass die Batterie 110 mit der Netzspannung verbunden und geladen wird.

Um den aktuellen Ladezustand der Batterie 110 ermitteln und daraus eine Prognose für die aktuelle Batterielaufzeit stellen zu können, kann die Steuer- und Auswerteeinrichtung 40 die Batteriequalität ermitteln. Im Unterschied zur Ladungsbilanzierung, die vorteilhafter weise Zyklus für Zyklus durchgeführt wird, kann die aktuelle Batteriequalität in größeren, parametrierbaren Zeitabständen geprüft werden. Die Batteriequalität ist durch einen Wert definiert, der angibt, wie groß die maximal verfügbare Batteriekapazität im Verhältnis zur Nennkapazität ist. Sinkt beispielsweise die Batteriequalität unter einen Wert von 80%, so gilt die Batterie 110 als verbraucht. Eine entsprechende Information kann die Steuer- und Auswerteeinrichtung 40 mittels der Anzeigeeinrichtung 50 darstellen.

Die Prüfung der Batteriequalität bzw. der maximal verfügbaren Batteriekapazität beginnt in Schritt 14 des in Fig. 1B gezeigten Flussdiagramms. In Schritt 14, der optional sein kann, ermittelt die Steuer- und Auswerteeinrichtung 40 in an sich bekannter Weise die Einsatzdauer der Batterie. Die Messung der Einsatzdauer kann permanent erfolgen. Unter Berücksichtigung der vom Temperaturdetektor 80 gemessenen, aktuellen Batterietemperatur und der gemessenen Einsatzdauer wird ein temperaturgewichteter Faktor ermittelt, der ein Maß für den sinkenden Wert der maximal verfügbaren Batteriekapazität darstellt. Hierzu kann die Steuer- und Auswerteeinrichtung 40 auf entsprechende Kennlinien zugreifen, die einen Verlustfaktor in Abhängigkeit der Einsatzdauer der Batterie bzw. deren Lebensdauer und der aktuellen Batterietemperatur angeben. Die Korrektur der maximal verfügbaren Batteriekapazität wird in Schritt 15 durchgeführt.

In Schritt 16 überwacht die Steuer- und Auswerteeinrichtung 40 permanent die Ladungsbilanzierung daraufhin, wann eine Stromentnahme aus der Batterie, d. h. ein Entladevorgang beendet worden ist. Ist ein Entladevorgang beendet worden, so ermittelt die Steuer- und Auswerteeinrichtung 40 die Entladeschlussspannung, auf die die Batterie 110 in dem jeweiligen Entladevorgang entladen worden ist und ordnet sie dem Wertebereich der Entladeschlussspannung zu, die gerade gemessen wird. Hierzu ist die Steuer- und Auswerteeinrichtung 40 mit einer entsprechenden Anzahl an Zählern 120 bis 130 verbunden, die jeweils einem der Wertebereiche der Entladeschlussspannung zugeordnet sind. Jeder von der Steuer- und Auswerteeinrichtung 40 festgestellte Entladevorgang wird somit in Abhängigkeit des Wertebereichs der festgestellten Entladeschlussspannung in dem jeweiligen Zähler gezählt. Die Steuer- und Auswerteeinrichtung 40 kann auf entsprechende Kennlinien zugreifen, die hinsichtlich des verwendeten Batterietyps für jeden Zählwert und jeden Wertebereich der Entladeschlussspannung einen entsprechenden Wert liefern. In Abhängigkeit der Zählerstände der Zähler 120, 130 ermittelt die Steuer- und Auswerteeinrichtung 40 dann einen Faktor, der wiederum ein Maß für die Abnahme der maximal verfügbaren Batteriekapazität ist. Darüber hinaus kann die Steuer- und Auswerteeinrichtung 40 auch die während eines Entladevorgangs gemessene, aktuelle Batterietemperatur mitberücksichtigen, um den Zählerstand der jeweiligen Zähler 120 und 130 temperaturgewichtet zu inkrementieren.

Aus den temperaturgewichteten Zählerständen kann dann die Steuer- und Auswerteeinrichtung 40 einen noch präziseren Wert für die Batteriequalität bzw. die maximal verfügbare Batteriekapazität ermitteln. Die entsprechende Berechnung der maximal verfügbaren Batteriekapazität wird in den Schritten 16 und 17 durchgeführt.

Ein weiteres Maß für die Abnahme der maximal verfügbaren Batteriekapazität kann aus dem dynamischen Innenwiderstand der Batterie 110 ermittelt werden. Zahlreiche Verfahren zum Berechnen des Innenwiderstandes der Batterie sind bekannt.

Im vorliegenden Beispiel kann der dynamische Innenwiderstand in Schritt 18 wie folgt gemessen werden: Angenommen sei zunächst, dass der dynamische Innenwiderstand der Batterie 110 bei voll geladener Batterie und temperaturkompensiert gemessen wird. Gemäß einer ersten Messmethode wird der Batteriespannung eine kleine Wechselspannung mit konstanter Frequenz, beispielsweise 100 Hz, überlagert und dann mittels des Stromdetektors 70 der Batteriewechselstrom gemessen. Der Innenwiderstand kann anschließend von der Steuer- und Auswerteeinrichtung 40 gemäß der Gleichung R_{I}=U_{EFF}/I_{EFF} berechnet werden.

Gemäß einem alternativen Messverfahren werden der Batterie 110 nacheinander zwei Gleichströme entzogen und daraus die entsprechenden Batteriespannungen gemessen. Der Innenwiderstand ergibt sich dann gemäß der Gleichung R_{I}=ΔU/ΔI. Um Temperatureinflüsse des Innenwiderstandes eliminieren zu können, wird der Messwert des Innenwiderstandes zusammen mit dem Messwert der aktuellen Batterietemperatur auf einen Widerstandswert bei einer normierten Temperatur umgerechnet. Diese normierten Widerstandswerte sind miteinander vergleichbar. Um den gemessenen Innenwiderstand hinsichtlich seines Einflusses auf die maximal verfügbare Batteriekapazität auswerten zu können, ist es notwendig, im Neuzustand der Batterie 110 einen Referenzwert zu messen und diesen zu speichern. Ein Maß über die abnehmende Batteriekapazität ergibt sich nunmehr aus dem Ansteigen des Innenwiderstandes.

In Schritt 19 wird anschließend die maximal verfügbare Batteriekapazität hinsichtlich der Veränderungen des Innenwiderstandes korrigiert.

An dieser Stelle sei angemerkt, dass ein Erstellen der erforderlichen Kennlinien zur Berechnung der Korrekturfaktoren für die Batteriekapazität sowie für den aktuellen Ladezustand der Batterie 110 nicht Gegenstand der Erfindung ist und daher nicht näher beschrieben wird.

Am Ende der Batteriequalitätsprüfung springt der Algorithmus zu Schritt 2 und der bereits beschriebene Ladungsbilanzierungsprozess beginnt erneut.

## Patentansprüche

1. Verfahren zum Überwachen und zur Angabe der maximal verfügbaren Kapazität einer Batterie, insbesondere einer wieder aufladbaren Batterie, mit folgenden Verfahrensschritten:
a) Bereitstellen mehrerer Zähler (120, 130) und Zuordnen der genannten Zähler jeweils einem Wertebereich einer Entladeschlussspannung, wobei die Entladeschlussspannung dadurch definiert ist, dass sie ein von einer Steuer- und Auswerteeinrichtung (40) nach Beendigung eines Entladevorgangs an der Batterie gemessener Spannungswert ist;
b) Entladen der Batterie durch Stromentnahme aus der Batterie und Überwachen, wann die Stromentnahme beendet worden ist;
c) Ermitteln, wenn die Stromentnahme beendet worden ist, des Entladeschlussspannungswerts, auf den die Batterie bei der Stromentnahme entladen worden ist;
d) Inkrementieren des Zählerstandes des Zählers, welcher dem Wertebereich des ermittelten Entladeschlussspannungswerts zugeordnet ist;
e) Wiederholen der Schritte b) bis d), nur dann, wenn die aktuelle, d.h. zuletzt gemessene Batteriespannung über einem Grenzwert liegt;
wobei das Verfahren ferner folgende Verfahrensschritte aufweist:
f) Auslesen der Zählerstände aller Zähler zu einem Zeitpunkt; und
g) Ermitteln eines ersten Faktors in Abhängigkeit von den ausgelesenen Zählerständen, welcher ein Maß für die Abnahme der maximal verfügbaren Batteriekapazität darstellt.

2. Verfahren nach Anspruch 1,
**dadurch gekennzeichnet, dass**
die Batterietemperatur gemessen wird und dass in Schritt d) der Zählerstand des jeweiligen Zählers temperaturgewichtet inkrementiert wird.

3. Verfahren nach Anspruch 1 oder 2,
**dadurch gekennzeichnet, dass**
die Batterietemperatur und eine Einsatzdauer der Batterie gemessen wird, und dass aus der gemessen Batterietemperatur und der gemessenen Einsatzdauer ein zweiter Faktor ermittelt wird, welcher ein weiters Maß für die Abnahme der maximal verfügbaren Batteriekapazität darstellt.

4. Verfahren nach einem der vorstehenden Ansprüche,
**dadurch gekennzeichnet, dass**
der Innenwiderstand der Batterie ermittelt wird, und dass in Abhängigkeit von dem ermittelten Innenwiderstand ein dritter Faktor bestimmt wird, welcher ein weiteres Maß für die Abnahme der maximal verfügbaren Batteriekapazität darstellt.

5. Verfahren nach einem der vorstehenden Ansprüche,
**dadurch gekennzeichnet, dass**
eine Ladestrom- und Entladestrombilanzierung durchgeführt wird, um den aktuellen Ladezustand der Batterie zu ermitteln, dass
im Batteriebetrieb der aktuelle Entladestrom gemessen wird, und dass
in Abhängigkeit vom aktuellen Ladezustand, vom aktuellen Entladestrom und von der maximal verfügbaren Batteriekapazität die zu erwartende Batterielaufzeit ermittelt wird.

6. Verfahren nach Anspruch 5,
**dadurch gekennzeichnet, dass**
vor Durchführung der Lade- und Entladestrombilanzierung die Kennwerte der Batterie gespeichert werden.

7. Verfahren nach Anspruch 6,
**dadurch gekennzeichnet, dass**
während der Lade- und Entladestrombilanzierung der aktuelle Batteriestrom, die aktuelle Batterietemperatur und/oder die aktuelle Batteriespannung gemessen werden.

8. Verfahren nach Anspruch 7,
**dadurch gekennzeichnet, dass** aus den Kennwerten der Batterie, dem aktuellen Batteriestrom, der aktuellen Batterietemperatur und/oder der aktuellen Batteriespannung der aktuelle Ladezustand ermittelt wird.

9. Vorrichtung zum Überwachen und zur Angabe der maximal verfügbaren Kapazität einer Batterie, insbesondere einer wieder aufladbaren Batterie, umfassend:
- eine zum Ausführen eines Verfahrens nach einem der Ansprüche 1 bis 8 ausgebildete Steuer- und Auswerteeinrichtung (40),
- Mittel zum Überwachen, wann eine Stromentnahme der Batterie beendet worden ist,
- Mittel zur Ermittlung der Entladeschlussspannung der Batterie (110), wenn eine Stromentnahme beendet worden ist,
- eine Speichereinrichtung (90) mit einer Anzahl von Wertbereichen der Entladeschlussspannung,
- eine Anzahl Zähler (120, 130), die jeweils einem der Wertbereiche der Entladeschlussspannung zugeordnet sind und das jeweilige Auftreten der Entladeschlussspannung in dem zugeordneten Wertebereich zählen,
- eine weitere Speichereinrichtung (100) von Batteriekennlinienwerten, und
- Mittel zur Bestimmung eines ersten Faktors in Abhängigkeit von den Zählerständen und den Batteriekennlinienwerten, wobei der erste Faktor ein Maß für die Abnahme der maximal verfügbaren Batteriekapazität darstellt.

10. Vorrichtung nach Anspruch 9,
weiter umfassend
- einen Temperaturdetektor (80) zum Messen der aktuellen Batterietemperatur
- eine Einrichtung zum Messen der Einsatzdauer der Batterie und
- Mittel zur Bestimmung eines zweiten Faktors aus der gemessen Batterietemperatur und der gemessenen Einsatzdauer, wobei der zweite Faktor ein weiteres Maß für die Abnahme der maximal verfügbaren Batteriekapazität darstellt.

11. Vorrichtung nach Anspruch 9 oder 10,
ferner umfassend
- Mittel zur Bestimmung des Innenwiderstandes der Batterie (110) und
- Mittel zur Bestimmung eines dritten Faktors in Abhängigkeit von dem ermittelten Innenwiderstand, wobei der dritte Faktor ein weiteres Maß für die Abnahme der maximal verfügbaren Batteriekapazität darstellt.

12. Vorrichtung nach den Ansprüchen 9 bis 11,
wobei
die Steuer- und Auswerteeinrichtung (40) zum Ermitteln der maximal verfügbaren Batteriekapazität den ersten Faktor berücksichtigt, und wobei
die Steuer- und Auswerteeinrichtung (40) zum Ermitteln der maximal verfügbaren Batteriekapazität den zweiten und/oder dritten Faktor berücksichtigt, sofern die Vorrichtung Mittel zur Bestimmung des jeweiligen Faktors umfasst.

13. Vorrichtung nach einem der vorstehenden Ansprüche 9 bis 12, wobei
die weitere Speichereinrichtung (100) zur Zuordnung der Kennwerte der Batterie zu den Zählständen der Zähler (120, 130) eingerichtet ist, und wobei ein Spannungsdetektor (60) zum Detektieren der aktuellen Batteriespannung und
ein Stromdetektor (70) zum Detektieren des aktuellen Batteriestroms vorgesehen sind,
wobei die Steuer- und Auswerteeinrichtung (40) Mittel zur Durchführung des Verfahrens nach einem der Ansprüche 5 bis 8 aufweist.

14. Unterbrechungsfreie Stromversorgung (30) mit einer Vorrichtung nach einem der Ansprüche 9 bis 13.

## Claims

1. A method for monitoring and indicating the maximum available capacity of a battery, in particular of a rechargeable battery, comprising the method steps of:
a) providing a plurality of counters (120, 130) and associating each of said counters to a respective value range of an end-of-discharge voltage, wherein the end-of-discharge voltage is defined by being a voltage value measured on the battery by a control and analysis device (40) after completion of a discharging operation;
b) discharging the battery by draining current from the battery and monitoring when the current drain has been terminated;
c) once the current drain has been terminated, determining the end-of-discharge voltage value to which the battery has been discharged during the current drain;
d) incrementing the count of the counter which is associated to the value range of the determined end-of-discharge voltage value;
e) repeating steps b) to d) only, if the actual, i.e. the last measured battery voltage is above a threshold;
wherein the method further comprises the method steps of:
f) reading off the counts of all counters at a time; and
g) determining, based on the counts readant from the counters, a first factor which represents a measure of a decline in the maximum available battery capacity.

2. The method according to claim 1,
**characterized in that** the battery temperature is measured, and that in step d) the count of the respective counter is incremented with temperature-weighting.

3. The method according to claim 1 or 2,
**characterized in that** the temperature of the battery and a duration of use of the battery is measured, and that based on the measured battery temperature and the measured duration of use a second factor is determined which represents a further measure of the decline in the maximum available battery capacity.

4. The method according to any one of the preceding claims,
**characterized in that** the internal resistance of the battery is determined, and that based on the determined internal resistance a third factor is determined which represents a further measure of the decline in the maximum available battery capacity.

5. The method according to any one of the preceding claims,
**characterized in that**
a charging current and discharging current accounting is performed to determine the actual charge status of the battery; that
the actual discharge current is measured during operation of the battery; and that
an anticipated battery operating time is determined based on the actual charge status, the actual discharge current, and the maximum available battery capacity.

6. The method according to claim 5,
**characterized in that** before performing the charging current and discharging current accounting, the characteristic values of the battery are stored.

7. The method according to claim 6,
**characterized in that** during the charging current and discharging current accounting, the actual battery current, the actual battery temperature and/or the actual battery voltage are measured.

8. The method according to claim 7,
**characterized in that** the actual charge status is determined based on the characteristic values of the battery, the actual battery current, the actual battery temperature and/or the actual battery voltage.

9. A device for monitoring and indicating the maximum available capacity of a battery, in particular of a rechargeable battery, comprising:
- a control and analysis device (40) configured for carrying out a method according to any one of claims 1 to 8;
- means for monitoring when a current drain of the battery has been terminated;
- means for determining the end-of-discharge voltage of the battery (110) once a current drain has been terminated;
- a memory means (90) including a plurality of value ranges of the end-of-discharge voltage;
- a plurality of counters (120, 130) each one associated with a respective one of the value ranges of the end-of-discharge voltage and counting a respective occurrence of the end-of-discharge voltage in the associated value range;
- a further memory means (100) for battery characteristic values; and
- means for determining a first factor based on the counts of counters and the battery characteristic values, wherein the first factor represents a measure of the decline in the maximum available battery capacity.

10. The device according to claim 9,
further comprising
- a temperature detector (80) for measuring the actual battery temperature;
- a means for measuring the duration of use of the battery; and
- means for determining a second factor based on the measured battery temperature and the measured duration of use, wherein the second factor represents a further measure of the decline in the maximum available battery capacity.

11. The device according to claim 9 or 10,
further comprising
- means for determining the internal resistance of the battery (110); and
- means for determining a third factor based on the determined internal resistance, wherein the third factor represents a further measure of the decline in the maximum available battery capacity.

12. The device according to claims 9 to 11, wherein the control and analysis device (40) takes into account the first factor for determining the maximum available battery capacity; and wherein
the control and analysis device (40) takes into account the second and/or third factor for determining the maximum available battery capacity, provided that the device comprises means for determining the respective factor.

13. The device according to any one of the preceding claims 9 to 12, wherein
the further memory means (100) is configured to associate the characteristic values of the battery with the counts of the counters (120, 130); and wherein
a voltage detector (60) is provided for detecting the actual battery voltage; and
a current detector (70) is provided for detecting the actual battery current;
wherein the control and analysis device (40) comprises means for carrying out the method according to any one of claims 5 to 8.

14. An uninterruptible power supply (30), comprising a device according to any one of claims 9 to 13.

## Revendications

1. Procédé de surveillance et d'indication de la capacité maximale disponible d'une batterie, en particulier d'une batterie rechargeable, comprenant les étapes de procédé suivantes :
a) fournir plusieurs compteurs (120, 130) et affecter lesdits compteurs à une plage respective de valeurs d'une tension finale de décharge, où la tension finale de décharge est définie par le fait qu'elle est une valeur de tension mesurée sur la batterie par un système de commande et d'évaluation (40) à la fin d'une procédure de décharge ;
b) décharger la batterie par consommation de courant de la batterie et surveiller le moment où un terme a été mis à la consommation de courant ;
c) déterminer, lorsqu'un terme a été mis à la consommation de courant, la valeur de tension finale de décharge à laquelle la batterie à été déchargée lors de la consommation de courant ;
d) incrémenter le relevé du compteur, lequel est affecté à la plage de valeurs de la valeur de tension finale de décharge déterminée ;
e) répéter les étapes b) à d) uniquement lorsque la tension actuelle de la batterie, mesurée pour la dernière fois, dépasse une valeur limite ;
le procédé comprenant en outre les étapes de procédé suivantes :
f) consulter les relevés de tous les compteurs à un certain moment ; et
g) déterminer un premier facteur en fonction des relevés de compteurs consultés, lequel représente une mesure de la baisse de la capacité maximale disponible de la batterie.

2. Procédé selon la revendication 1, **caractérisé en ce que** la température de la batterie est mesurée et **en ce que**, à l'étape d), le relevé du compteur respectif est incrémenté avec pondération de la température.

3. Procédé selon la revendication 1 ou 2, **caractérisé en ce que** la température de la batterie et la durée d'utilisation de la batterie sont mesurées, et **en ce qu'**un deuxième facteur, lequel représente une autre mesure de la baisse de la capacité maximale disponible de la batterie, est déterminé à partir de la température mesurée de la batterie et de la durée d'utilisation mesurée.

4. Procédé selon l'une quelconque des revendications précédentes, **caractérisé en ce que** la résistance intérieure de la batterie est déterminée, et **en ce qu'**un troisième facteur est défini en fonction de la résistance intérieure déterminée, lequel représente une autre mesure de la baisse de la capacité maximale disponible de la batterie.

5. Procédé selon l'une quelconque des revendications précédentes, **caractérisé en ce que** :
un bilan du courant de charge et du courant de décharge est établi afin de déterminer l'état actuel de charge de la batterie, **en ce que**
le courant actuel de décharge est mesuré lorsque la batterie est en fonctionnement, et **en ce que**
le temps de fonctionnement attendu de la batterie est déterminé, en fonction de l'état actuel de charge, du courant actuel de décharge et de la capacité maximale disponible de la batterie.

6. Procédé selon la revendication 5, **caractérisé en ce que** les valeurs caractéristiques de la batterie sont mises en mémoire avant l'établissement du bilan du courant de charge et du courant de décharge.

7. Procédé selon la revendication 6, **caractérisé en ce que**, pendant l'établissement du bilan du courant de charge et du courant de décharge, le courant actuel de la batterie, la température actuelle de la batterie et/ou la tension actuelle de la batterie sont mesurés.

8. Procédé selon la revendication 7, **caractérisé en ce que** l'état actuel de charge est déterminé à partir des valeurs caractéristiques de la batterie, du courant actuel de la batterie, de la température actuelle de la batterie et/ou de la tension actuelle de la batterie.

9. Dispositif de surveillance et d'indication de la capacité maximale disponible d'une batterie, en particulier d'une batterie rechargeable, comprenant :
- un système de commande et d'évaluation (40) conçu pour mettre en oeuvre un procédé selon l'une quelconque des revendications 1 à 8,
- des moyens pour surveiller le moment où un terme a été mis à une consommation de courant de la batterie,
- des moyens pour déterminer la tension finale de décharge de la batterie (110), lorsqu'un terme a été mis à une consommation de courant,
- un dispositif mémoire (90) comprenant un certain nombre de plages de valeurs de la tension finale de décharge,
- un certain nombre de compteurs (120, 130), qui sont affectés à l'une des plages de valeurs de la tension finale de décharge et qui comptent chaque apparition de la tension finale de décharge dans la plage de valeurs affectée,
- un autre dispositif mémoire (100) de valeurs de courbes caractéristiques de batterie, et
- des moyens pour définir un premier facteur en fonction des relevés des compteurs et des valeurs de courbes caractéristiques de batterie, le premier facteur représentant une mesure de la baisse de la capacité maximale disponible de la batterie.

10. Dispositif selon la revendication 9, comprenant en outre :
- un détecteur de température (80) pour la mesure de la température actuelle de la batterie,
- un système de mesure de la durée d'utilisation de la batterie, et
- des moyens pour définir un deuxième facteur à partir de la température mesurée de la batterie et de la durée d'utilisation mesurée, le deuxième facteur représentant une autre mesure de la baisse de la capacité maximale disponible de la batterie.

11. Dispositif selon la revendication 9 ou 10, comprenant en outre :
- des moyens pour définir la résistance intérieure de la batterie (110), et
- des moyens pour définir un troisième facteur en fonction de la résistance intérieure déterminée, le troisième facteur représentant une autre mesure de la baisse de la capacité maximale disponible de la batterie.

12. Dispositif selon les revendications 9 à 11, dans lequel :
le système de commande et d'évaluation (40) prend en compte le premier facteur pour déterminer la capacité maximale disponible de la batterie, et dans lequel
le système de commande et d'évaluation (40) prend en compte le deuxième facteur et/ou le troisième facteur pour déterminer la capacité maximale disponible de la batterie, pour autant que le dispositif comporte des moyens pour définir le facteur respectif.

13. Dispositif selon l'une quelconque des revendications précédentes 9 à 12, dans lequel :
l'autre dispositif mémoire (100) est conçu pour affecter les valeurs caractéristiques de la batterie aux relevés des compteurs (120, 130), et dans lequel
un détecteur de tension (60) destiné à détecter la tension actuelle de la batterie et un détecteur de courant (70) destiné à détecter le courant actuel de la batterie sont prévus,
dans lequel le système de commande et d'évaluation (40) comprend des moyens pour la mise en oeuvre du procédé selon l'une quelconque des revendications 5 à 8.

14. Alimentation ininterrompue en courant (30) comprenant un dispositif selon l'une quelconque des revendications 9 à 13.
